# EUROPEAN PATENT SPECIFICATION

(11) **EP 4 233 166 B1**
(45) Date of publication and mention of the grant of the patent: **03.06.2026**
(21) Application number: 21831000.1
(22) Date of filing: 07.12.2021
(51) Int. Cl.: H02M 3/335, H02M 1/40, H05B 45/385, H05B 45/382, G01R 15/18

(54) **SYNCHRONOUS CONVERTER AND LIGHTING SYSTEM COMPRISING THE SAME**
SYNCHRONWANDLER UND BELEUCHTUNGSSYSTEM DAMIT
CONVERTISSEUR SYNCHRONE ET SYSTÈME D'ÉCLAIRAGE LE COMPRENANT

(30) Priority: 07.12.2020 EP 20212092
(43) Date of publication of application: 30.08.2023
(73) Proprietor: Tridonic GmbH & Co. KG, 6851 Dornbirn (AT)
(72) Inventor: LOCHMANN, Frank, 6850 Dornbirn (AT)
(74) Representative: Rupp, Christian
(86) International application number: PCT/EP2021/084519
(87) International publication number: WO 2022/122703

(56) References cited:
- US-A1- 2007 115 700
- US-A1- 2008 129 437
- US-A1- 2014 232 282
- US-A1- 2015 180 357
- US-A1- 2019 267 905

## Description

### Technical Field

The present invention relates to a converter, and in particular, to a synchronous converter for lighting systems.

### Background Art

Exemplary switched-mode power converters typically regulate an electrical quantity at their output terminals, such as a load current, in accordance with a signal that is sensed at the respective output. Given a galvanic insulation between the input and output terminals for safety and/or statutory reasons, it may be required to transfer the sensed signal via the galvanic insulation to a controller. Using opto-isolators (a.k.a. opto-couplers) in this connection may be cost-prohibitive, whereas deploying exemplary current sensing transformers may result in sensing inaccuracies due to direct current (DC) offsets.

US 2015/180357 A1 discloses a primary-side switched and isolated converter in accordance with a preamble of independent claim 1.

### Summary of the Invention

The object of the present invention is to provide a synchronous converter capable of solving this and other problems of the prior art.

The invention is defined by the appended independent claims. Preferred embodiments are set forth in the dependent claims and in the following description and drawings.

According to a first aspect of the present disclosure, a primary-side switched and isolated converter with output terminals for driving LED lighting means is provided in accordance with claim 1. The converter comprises: a transformer, acting as isolation stage, configured to couple a primary side and a secondary side of the converter; and at least one switch on the primary side. The secondary side comprises a smoothing capacitor for smoothing a secondary side current induced in a secondary winding of the transformer connected to the secondary side and for supplying a smoothed load current induced in the LED lighting means when connected to the output terminals even in periods in which no secondary side current is induced in the secondary winding. The secondary side further comprises a current sensing transformer for sensing an indication of the load current induced in the LED lighting means when connected to the output terminals. The current sensing transformer comprises a bifilar primary winding. A first filament of the bifilar primary winding is configured to conduct the secondary side current induced in the secondary winding of the transformer connected to the secondary side. A second filament of the bifilar primary winding is configured to conduct the load current. The first and second filaments are counter-wound to induce mutually opposing magnetic fluxes in the current sensing transformer. The smoothing capacitor is connected between the output terminal and a node between the first filament and the second filament.

(Note that the terms "bifilar" and "filament(s)" are solely used to distinguish the windings of the sensing transformer from the windings of the isolation stage transformer.)

The converter may comprise isolated converters such as e.g. a synchronous flyback converter, a flyback converter, an LCC converter etc. This ensures a galvanic isolation between the primary side and secondary side, and allows for a wide range of applications.

The current sensing transformer further comprises a secondary sense winding providing a current sense current in dependence of the secondary side current and the load current.

The converter may further comprise a sample-and-hold circuit for sampling a current sense voltage indicative of the current sense current during a secondary side non-conduction period of a switch of the secondary side.

A polarity of the secondary sense winding may be arranged to provide a positive current sense current during the secondary side non-conduction period.

The converter may further comprise a shunt circuit for sensing a voltage indicative of a primary side current fed into a primary winding of the transformer connected to the primary side. The sample-and-hold circuit is configured to sample synchronously to zero-crossings of the primary side current.

The sample-and-hold circuit is configured to sample at or within a predetermined time period of zero-crossings of the primary side current.

The converter may further comprise a controller configured for a feedback control of a mean value of the load current in accordance with the samples of the current sense voltage, by controlling a switching operation of the at least one switch on the primary side.

The controller may be subject to an electric potential of the primary side of the converter.

According to a second aspect, a lighting system is provided, comprising: an synchronous converter according to the first aspect or any of its embodiments, and LED lighting means configured to be supplied by the synchronous converter.

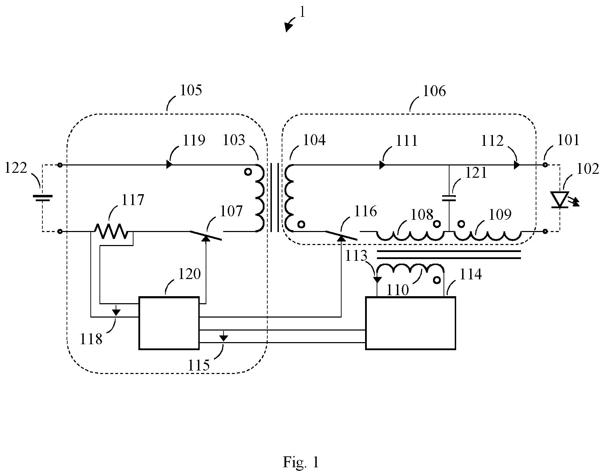

The present disclosure provides a converter and a lighting system which, by deploying a current sensing transformer with a counter-wound bifilar primary winding, may partially compensate a magnetic flux induced by the secondary side current in the first filament of the bifilar primary winding with a magnetic flux induced by the load current in the second filament of the bifilar primary winding. As the smoothing capacitor (see Fig. 1) effectively blocks DC, a DC component of the secondary side current substantially corresponds to a DC component of the load current. Hence, the current sensing transformer may transfer substantially an AC component of the secondary side current to its secondary sense winding. This avoids a saturation of the ferrite material of the core of the current sensing transformer by a substantial DC component in the current conducted by the primary winding, which DC component may give rise to sensing inaccuracies due to DC offsets. As a result, galvanic isolation and highly accurate sensing may be achieved at low cost.

### Brief Description of the Drawings

Further aspects, advantages and objects of the invention will become evident for the skilled reader by means of the following detailed description of the embodiments of the invention, when taking into conjunction with the figures of the enclosed drawings.
Fig. 1 illustrates a synchronous converter and a lighting system according to embodiments of the present disclosure.
Fig. 2 illustrates an example of a non-synchronous converter and a lighting system according to embodiments of the present disclosure.
Fig. 3 illustrates another non-synchronous converter and a lighting system according to embodiments of the present disclosure.
Fig. 4 illustrates a timing of a sampling of a current sense voltage indicative of the current sense current.

### Detailed Descriptions of Embodiments

The invention will now be described with respect to various embodiments. The features of these embodiments may be combined with each other unless specified otherwise.

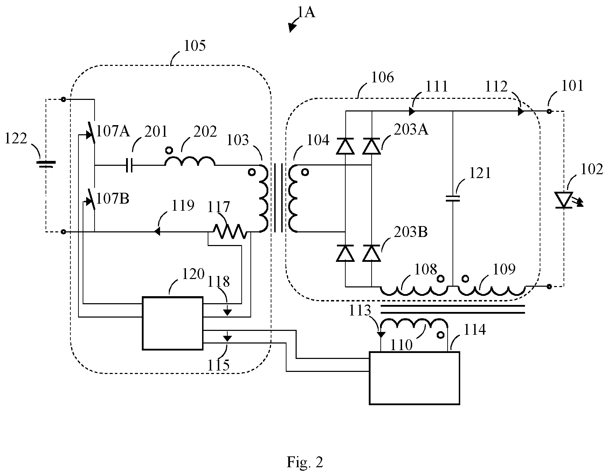

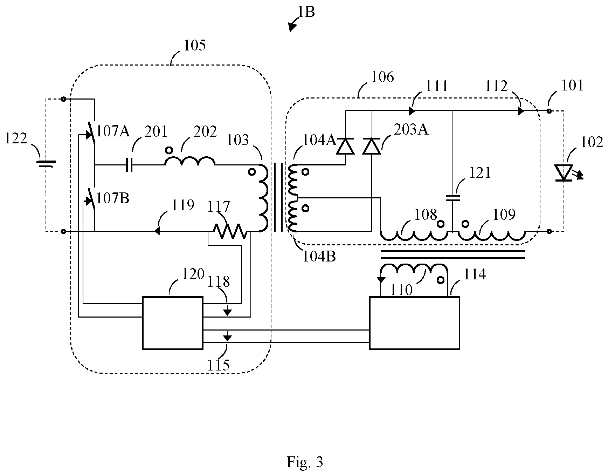

Fig. 1 illustrates a synchronous flyback converter 1 and a lighting system 1, 102 according to embodiments of the present disclosure. The shown converter is just an example of an isolated switch converter. Different types of resonant or non-resonant isolated converter may be used, such as e.g. example a flyback converter, an LCC converter (being an example of a resonant converter, see Figs. 2 and 3 below) etc.

The synchronous converter 1 is primary-side switched, isolated and provided with output terminals 101 for driving LED lighting means 102. The lighting system 1, 102 is formed by a combination of the synchronous converter 1 and such LED lighting means 102, which are configured to be supplied by the synchronous converter 1.

Fig. 1 shows that the isolated converter 1 comprises a transformer 103, 104 configured to couple a primary side 105 and a secondary side 106 of the converter 1. The primary and secondary sides 105, 106 are indicated by rounded boxes having dashed lines.

Primary and secondary sides as used herein may refer to different electric potentials that are isolated from one another galvanically and coupled with one another magnetically.

In particular, the converter 1 may comprise a (optionally synchronous) flyback converter.

A flyback converter as used herein may refer to a switched-mode power converter of buck-boost converter type with galvanic isolation between its input and output terminals.

The primary side 105 comprises at least one switch 107 configured to enable or disable a flow of a primary side current 119 from a DC power source 122 connectable to the primary side 105 into a primary winding 103 of the transformer 103, 104.

A switch as used herein may refer to a solid-state power switch, such as a Metal-Oxide Semiconductor Field-Effect Transistor (MOSFET), Bipolar Transistor or an Insulated Gate Bipolar Transistor (IGBT).

Those skilled in the art will appreciate that synchronous converters as the one illustrated in Fig. 1 are further provided with a switch 116 on the secondary side 106 which may replace a rectifying diode and may be off / open / non-conductive when the at least one switch 107 of the primary side 105 is on / closed / conductive (ON-period), and vice versa. In other words, the switches 107, 116 have non-overlapping ON-periods in order to alternatingly store energy in and retrieve energy from a magnetic field in a core of the transformer 103, 104. Fig. 1 shows that an operation of the switch 116 on the secondary side 106 may be controlled by the controller 120, although other configurations are conceivable as well.

Non-synchronous isolated converter (e.g. normal flyback converter, isolated LLC converter etc) do not have such actively controlled switch 116, but rather a passive diode or diode network. The switch 116 therefore can be formed by an actively controlled switch or by a passive switching element such as e.g. one or more diode(s) which blocking a current under certain conditions.

In any event, the switch 116 may be configured to enable or disable a flow of a secondary side current 111 induced in a secondary winding 104 of the transformer 103, 104 connected to the secondary side 106.

The secondary side 106 comprises a smoothing capacitor 121 for smoothing the secondary side current 111, and for supplying a smoothed load current 112 induced in the LED lighting means 102 when connected to the output terminals 101 even in periods in which no secondary side current 111 is induced in the secondary winding 104.

According to Fig. 1, the secondary side 106 further comprises a current sensing transformer 108 -110 for sensing an indication of the load current 112. The current sensing transformer 108 -110 comprises a bifilar primary winding 108, 109. A first filament 108 of the bifilar primary winding 108, 109 is configured to conduct the secondary side current 111, and a second filament 109 of the bifilar primary winding 108, 109 is configured to conduct the load current 112. The first and second filaments 108, 109 are configured to induce mutually opposing magnetic fluxes in the current sensing transformer 108 -110. In other words, the bifilar primary winding 108, 109 is counter-wound, as may be taken from Fig. 1 by noting that the primary windings 108, 109 have opposite directions of magnetic flux.

(Note that the terms "bifilar" and "filament(s)" are used to distinguish the windings of the sensing transformer from the windings of the isolation stage transformer.)

A current sensing transformer as used herein may refer to a transformer configured to convert a high primary current to be measured into a smaller secondary sensing current, based on Faraday's law of induction. Current sensing transformer provide an intrinsic galvanic insolation between the current to be measured and the sensing current. Being a passive device, no extra driving circuitry and little power are needed.

An indication as used herein may refer to a sensed quantity that may serve to indicate a quantity to be measured. In other words, the sensed quantity is a function of the quantity to be measured.

Bifilar as used herein may refer to involving two elementary wires.

A filament as used herein may refer to any elementary wire of a bifilar wire.

According to Fig. 1, the current sensing transformer 108 -110 may further comprise a secondary sense winding 110 for providing a current sense current 113 in dependence of the secondary side current 111 and the load current 112.

As mentioned above, a magnetic flux induced by the secondary side current in the first filament 108 of the bifilar primary winding 108, 109 may partially be compensated by a magnetic flux induced by the load current 112 in the second filament 109 of the bifilar primary winding 108, 109. As a DC component of the secondary side current 111 substantially corresponds to a DC component of the load current 112, the current sensing transformer 108 -110 may transfer substantially the AC component of the secondary side current 111 to its secondary sense winding 110. In time periods during which no secondary side current 111 is flowing through the first filament 108, this first filament 108 will have no magnetic flux and the only magnetic flux to the bifilar primary winding 108, 109 will be induced by the second filament 109.

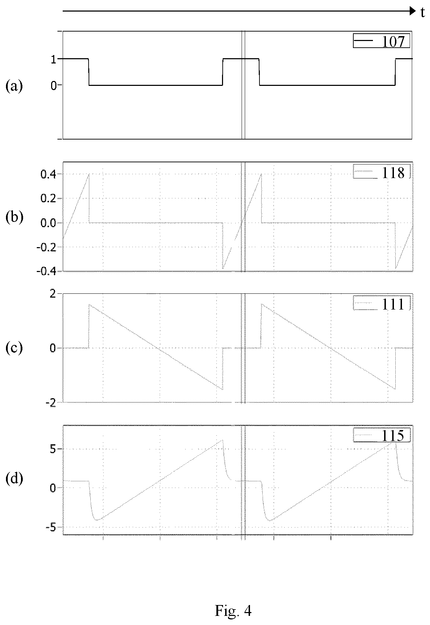

According to Fig. 1, the synchronous converter 1 may further comprise a sample-and-hold circuit 114 for sampling a current sense voltage 115, v_{cs} indicative of the current sense current 113. Details on a timing of the sampling will be explained in connection with Fig. 4. below.

Those skilled in the art will appreciate that sampled values may be passed on as digital values. In Fig. 1, a transfer of the current sense voltage 115, v_{cs} as analog values is indicated for descriptive reasons (i.e., in order to depict the current sense voltage 115, v_{cs} as).

Those skilled in the art will further appreciate that there is a degree of freedom regarding a polarity of the secondary sense winding 110 with respect to the corresponding electrical terminals of the sample-and-hold circuit 114. In particular, a polarity of the secondary sense winding 110 may be arranged to provide a positive current sense current 113 during periods in which the secondary side 106 does not carry any secondary side current 111.

According to Fig. 1, the synchronous converter 1 may further comprise, on its primary side 105, a shunt circuit 117 for sensing a voltage 118, vₛₕᵤₙₜ indicative of a primary side current 119 fed into a primary winding 103 of the transformer 103, 104 connected to the primary side 105.

A shunt as used herein may refer to a device configured to establish a low-resistance path for electric current, such as a shunt resistor.

The sample-and-hold circuit 114 may be configured to perform sampling in accordance with the primary side current 119, as will also be explained in connection with Fig. 4. below.

A sample-and-hold circuit as used herein may refer to a device configured to sample an electrical quantity, such as a voltage, of an analog signal and to hold the sampled value constant for a specified minimum period of time.

According to Fig. 1, the synchronous converter 1 may further comprise, on its primary side 105, a controller 120 configured for a feedback control of a mean value of the load current 112 in accordance with the sampled current sense voltage 115, v_{cs}, by controlling a switching operation of the at least one switch 107 on the primary side 105. The synchronous converter 1 may be controlled depending on the mean value of the load current 112 in accordance with the sampled current sense voltage 115, v_{cs}. For instance the ON-period of the switch 107 of the primary side 105 and / or the OFF-period of the switch 107 of the primary side 105 may depend on the mean value of the load current 112. The controller 120 may sense the sampled current sense voltage 115, v_{cs} and / or the sensed voltage 118, vshunt at the shunt circuit 117 which is indicative of a primary side current 119 fed into the primary winding 103 of the transformer 103, 104 to control the load current 112 for the LED lighting means 102.

In particular, the controller 120 may be subject to an electric potential of the primary side 105 of the converter 1. In other words, a ground potential of the controller 120 may correspond to a ground potential of the primary side 105. Depending on the desired application of the synchronous converter 1, this may require a galvanic isolation of the sample-and-hold circuit 114 connected to the controller 120 from an electric potential of the secondary side 106. This may be achieved by deploying the current sensing transformer 108 -110.

Fig. 2 illustrates a non-synchronous converter 1A and a lighting system 1A, 102 according to embodiments of the present disclosure.

The non-synchronous converter 1A comprises a first example of a resonant LLC converter.

On the primary side 105 of the converter 1A, the at least one switch 107 comprises two switches 107A, 107B being configured for alternating symmetric operation. The switches 107A, 107B may be controlled by frequency modulation depending on the sensed load current 112.

As such, the controller 120 is configured for a feedback control of a mean value of the load current 112 in accordance with the sampled current sense voltage 115, v_{cs}, by controlling a switching operation of the two switches 107A, 107B on the primary side 105.

The full voltage of the DC power source 122 is thus chopped, and the resulting square-wave voltage with 50% duty cycle is applied to a resonant tank comprising capacitor 201 (_{RES}) and inductor 202 (L_{RES}) in connection with a leakage inductance (L_{M}) of the primary winding 103.

On the secondary side 106 of the converter 1A, a full-wave (i.e., Graetz bridge) rectifier comprising secondary winding 104 and diode pairs 203A, 203B as blocking elements may be configured to alternatingly enable or disable the flow of the secondary side current 111 induced in the secondary winding 104 of the transformer 103, 104 connected to the secondary side 106.

At the moment when diode pairs 203A, 203B are blocked due to the fact that the voltage over the smoothing capacitor 121 exceeds the voltage over the secondary winding 104 of the transformer 103, 104, the diode pairs 203A, 203B act as closed switches or blocking elements which disable the flow of the secondary side current 111 induced in the secondary winding 104 of the transformer 103, 104 connected to the secondary side 106. In the moment where no secondary side current 111 is flowing through the first filament 108 will have no magnetic flux and the only magnetic flux to the bifilar primary winding 108, 109 will be induced by the second filament 109.

All other elements of the non-synchronous converter 1A correspond to those of the synchronous converter 1 and are therefore indicated using the same reference signs.

Fig. 3 illustrates another non-synchronous converter 1B and a lighting system 1B, 102 according to embodiments of the present disclosure.

The non-synchronous converter 1B comprises a second example of a resonant LLC converter.

A primary side 105 of the converter 1B corresponds to the primary side 105 of the converter 1A.

On the secondary side 106 of the converter 1B, a full-wave rectifier comprising a center-tapped secondary winding 104A, 104B and the diode pair 203A as blocking elements may be configured to alternatingly enable or disable the flow of the secondary side current 111 induced in the secondary winding 104A, 104B of the transformer 103, 104 connected to the secondary side 106. Of note, twice as many turns are required on the secondary winding 104A, 104B to obtain a same load voltage than for the Graetz bridge rectifier of Fig. 2.

Again, all other elements of the non-synchronous converter 1B correspond to those of the synchronous converter 1 and therefore share reference signs.

Fig. 4 illustrates for an example of the invention explained for the circuit according to Fig. 1 a timing of a sampling of a current sense voltage 115, v_{cs} indicative of the current sense current 113, i_{cs}.

According to Fig. 4(a), a pulse modulation (PM) drive signal, e.g. pulse width modulation (PWM) drive signal may be applied to the at least one switch 107 on the primary side 105 of the synchronous converter 1 of Fig. 1. For example, the PM drive signal may be applied to a gate of a switch 107. The duration of the ON-period of the PM drive signal may depend on the sensed voltage 118, vshunt at the shunt circuit 117 which is indicative of a primary side current 119 fed into the primary winding 103 of the transformer 103, 104 connected to the primary side 105.

According to Fig. 4(b), ON-periods of the drive signal shown in Fig. 4(a) consistently coincide with flows of the primary side current 119 into the primary winding 103 of the transformer 103, 104, as is measured by the voltage 118, vₛₕᵤₙₜ indicative of the primary side current 119. At a beginning of the respective ON-period, the primary side current 119 sharply drops to a negative peak owing to a persisting magnetic flux in the transformer 103, 104, as the at least one switch 107 on the primary side 105 becomes conductive. At an end of the respective ON-period, the primary side current 119 sharply drops from a positive peak as the at least one switch 107 on the primary side 105 becomes non-conductive. At some point within the respective ON-period, the primary side current 119 crosses from negative to positive currents. Such events may be termed 'zero-crossings'.

As mentioned above, the at least one switch 107 on the primary side 105 and the switch 116 on the secondary side 106 have non-overlapping ON-periods. That is to say, during an ON-period of the at least one switch 107 on the primary side 105, the switch 116 on the secondary side 106 is in an OFF-period and vice versa. Accordingly, a zero-crossing of the primary side current 119 shown in Fig. 4(b) may be used as an easily detectable indication of an OFF-period of the switch 116 on the secondary side 106.

According to Fig. 4(c), ON-periods of the drive signal shown in Fig. 4(a) consistently coincide with no conduction of any secondary side current 111 on the secondary side 106 or, in other words, with secondary side non-conduction periods of the switch 116 of the secondary side 106. As the switch 116 is open (non-conducting) during the ON-period of the switch 107 it is blocking any secondary side current 111 on the secondary side 106.

Fig. 4(d) illustrates the current sense voltage 115, v_{cs} indicative of the current sense current 113 provided by the current sensing transformer 108 -110 in dependence of the secondary side current 111 and the load current 112.

As mentioned above, a magnetic flux induced by the secondary side current in the first filament 108 of the bifilar primary winding 108, 109 may partially be compensated by a magnetic flux induced by the load current 112 in the second filament 109 of the bifilar primary winding 108, 109. As a DC component of the secondary side current 111 may substantially correspond to a DC component of the load current 112, the current sensing transformer 108 -110 may transfer substantially an AC component of the secondary side current 111 to its secondary sense winding 110. That is to say, the current sense voltage 115, v_{cs} is indicative of the current sense current 113, and the current sense current 113 is in turn indicative of the AC component of the secondary side current 111.

As may be taken from Fig. 4(d), a polarity of the secondary sense winding 110 has been arranged appropriately to provide a positive current sense current 113 during the above-mentioned secondary side non-conduction period.

Accordingly, an average (i.e., mean value) of the AC component of the secondary side current 111 may be sampled during said secondary side non-conduction period of the switch 116 of the secondary side 106. To this end, the sample-and-hold circuit 114 may be configured to sample synchronously to zero-crossings of the primary side current 119 (see Fig. 4(b)).

More specifically, the sample-and-hold circuit 114 may be configured to sample at or within a predetermined time period of zero-crossings of the primary side current 119. For example, the predetermined time period may comprise 100%, preferably 50% and most preferably 10% of the respective ON-period of the drive signal shown in Fig. 4(a).

The example of Fig. 1 shows a synchronous flyback converter 1 with an actively controlled switch 116. As mentioned before the invention may be also applied for a non-synchronous flyback converter with a diode on the secondary side as passive switch 116. The diode as switch 116 will take over the secondary side current 111 on the secondary side 106 as soon as the switch 107 on the primary side 105 is opened and thus interrupts the primary side current 119 flowing through the primary side 115. Due to the magnetization of the transformer 103, 104 the voltage over the secondary winding 104 will turn on the switch 116 and thus drive a secondary side current 111. Such secondary side current 111 will flow as long as the transformer 103, 104is magnetized and the switch 107 on the primary side 105 is open. At the moment where the switch 107 on the primary side 105 is closed a primary side current 119 will flow through the primary side 115 and build up a voltage over the primary side winding 103. The voltage on the secondary side winding 104 in the secondary side 106 will now revert and the switch 116 will block the secondary side current 111 on the secondary side 106. With the blocked secondary side current 111 there will be no current flow in the first filament 108 of the bifilar primary winding 108, 109. The measurement with current sensing transformer (108, 109, 110) can now be performed according to the invention.

For the example of a non-synchronous flyback converter 1 the primary side switch 107 may be controlled by a pulse width modulation (PWM) drive signal which may be controlled depending on the sensed load current 112.

## Claims

1. A primary-side switched isolated converter (1) with output terminals (101) for driving LED lighting means (102), comprising:
a transformer (103, 104) configured to couple a primary side (105) and a secondary side (106) of the converter (1); and
at least one switch (107) on the primary side (105);
wherein the secondary side (106) comprises a smoothing capacitor (121) for smoothing a secondary side current (111) induced in a secondary winding (104) of the transformer (103, 104) connected to the secondary side (106) and for supplying a smoothed load current (112) induced in the LED lighting means (102) when connected to the output terminals (101) even in periods in which no secondary side current (111) is induced in the secondary winding (104);
wherein the secondary side (106) further comprises a current sensing transformer (108, 109, 110) for sensing an indication of the load current (112) induced in the LED lighting means (102) when connected to the output terminals (101);
**characterized in that**
the current sensing transformer (108, 109, 110) comprises a bifilar primary winding (108, 109) comprising a first filament (108) connected to a second filament (109), wherein the first and second filaments (108, 109) are counter-wound to induce mutually opposing magnetic fluxes in the current sensing transformer (108, 109, 110);
the smoothing capacitor (121) is connected between one of said output terminals (101) and a node between the first filament (108) and the second filament (109);
whereby said first filament (108) is configured to conduct a secondary side current (111) induced in the secondary winding (104) of the transformer (103, 104) connected to the secondary side (106), and said second filament (109) is configured to conduct the load current (112).

2. The isolated converter (1) of claim 1,
wherein the isolated converter (1) comprises a flyback, a synchronous flyback converter or an LLC converter.

3. The isolated converter (1) of any of the preceding claims,
wherein the current sensing transformer (108, 109, 110) further comprises a secondary sense winding (110) providing a current sense current (113) in dependence of the secondary side current (111) and the load current (112).

4. The isolated converter (1) of claim 3, further comprising
a sample-and-hold circuit (114) for sampling a current sense voltage (115, v_{CS}) indicative of the current sense current (113) during a secondary side non-conduction period of a switch (116) of the secondary side (106).

5. The isolated converter (1) of claim 4,
wherein a polarity of the secondary sense winding (110) is arranged to provide a positive current sense current (113) during the secondary side non-conduction period.

6. The isolated converter (1) of claim 4 or claim 5, further comprising
a shunt circuit (117) for sensing a voltage (118, vₛₕᵤₙₜ) indicative of a primary side current (119) fed into a primary winding (103) of the transformer (103, 104) connected to the primary side (105); and
wherein the sample-and-hold circuit (114) is configured to sample synchronously to zero-crossings of the primary side current (119).

7. The isolated converter (1) of claim 6,
wherein the sample-and-hold circuit (114) is configured to sample at or within a predetermined time period of zero-crossings of the primary side current (119).

8. The isolated converter (1) of any of the claims 4 to 7, further comprising
a controller (120) configured for a feedback control of a mean value of the load current (112) in accordance with the samples of the current sense voltage (115, v_{CS}), by controlling a switching operation of the at least one switch (107) on the primary side (105).

9. The isolated converter (1) of claim 8,
wherein the controller (120) is subject to an electric potential of the primary side (105) of the converter (1).

10. A lighting system (3), comprising:
an isolated converter (1) of any of the claims 1 to 9, and
LED lighting means (102) supplied off output terminals of the isolated converter (1).

## Patentansprüche

1. Primärseitig geschalteter isolierter Wandler (1) mit Ausgangsklemmen (101) zum Ansteuern von LED-Leuchtmitteln (102), umfassend:
einen Transformator (103, 104), der konfiguriert ist, eine Primärseite (105) und eine Sekundärseite (106) des Wandlers (1) zu koppeln; und
mindestens einen Schalter (107) auf der Primärseite (105);
wobei die Sekundärseite (106) einen Glättungskondensator (121) zum Glätten eines in einer Sekundärwicklung (104) des Transformators (103, 104) induzierten Sekundärstroms (111) umfasst und dazu dient, einen geglätteten Laststrom (112), der im LED-Leuchtmittel (102) induziert wird, bereitzustellen, wenn dieses an die Ausgangsklemmen (101) angeschlossen ist, selbst während Zeiträumen, in denen kein Sekundärstrom (111) in der Sekundärwicklung (104) induziert wird;
wobei die Sekundärseite (106) ferner einen Strommesstransformator (108, 109, 110) zum Erfassen einer Anzeige des Laststroms (112) im LED-Leuchtmittel (102) umfasst, wenn dieses an die Ausgangsklemmen (101) angeschlossen ist;
**dadurch gekennzeichnet, dass** der Strommesstransformator (108, 109, 110) eine bifilare Primärwicklung (108, 109) umfasst, die einen ersten Leiter (108) und einen zweiten Leiter (109) aufweist, welche miteinander verbunden sind und gegensinnig gewickelt sind, um im Strommesstransformator (108, 109, 110) einander entgegengesetzte magnetische Flüsse zu induzieren;
dass der Glättungskondensator (121) zwischen einer der genannten Ausgangsklemmen (101) und einem Knotenpunkt zwischen dem ersten Leiter (108) und dem zweiten Leiter (109) angeschlossen ist;
wodurch der erste Leiter (108) dafür eingerichtet ist, einen in der Sekundärwicklung (104) des Transformators (103, 104) induzierten Sekundärstrom (111) zu führen, und der zweite Leiter (109) dafür eingerichtet ist, den Laststrom (112) zu führen.

2. Der isolierte Wandler (1) nach Anspruch 1, wobei der isolierte Wandler (1) ein Sperrwandler, ein synchroner Sperrwandler oder ein LLC-Wandler ist.

3. Der isolierte Wandler (1) nach einem der vorhergehenden Ansprüche, wobei der Strommesstransformator (108, 109, 110) ferner eine sekundäre Messwicklung (110) umfasst, die einen Messstrom (113) in Abhängigkeit vom Sekundärstrom (111) und vom Laststrom (112) bereitstellt.

4. Der isolierte Wandler (1) nach Anspruch 3, ferner umfassend eine Abtast-Halte-Schaltung (114) zum Abtasten einer Strommessspannung (115, V), die den Messstrom (113) anzeigt, während einer Nichtleitphase eines Schalters (116) der Sekundärseite (106).

5. Der isolierte Wandler (1) nach Anspruch 4, wobei die Polarität der sekundären Messwicklung (110) so gewählt ist, dass sie während einer Nichtleitphase eines Schalters (116) der Sekundärseite (106) einen positiven Messstrom (113) liefert.

6. Der isolierte Wandler (1) nach Anspruch 4 oder 5, ferner umfassend eine Shunt-Schaltung (117) zum Erfassen einer Spannung (118, V), die einen in eine Primärwicklung (103) des mit der Primärseite (105) verbundenen Transformators (103, 104) eingespeisten Primärstrom (119) anzeigt; und wobei die Abtast-Halte-Schaltung (114) dazu konfiguriert ist, synchron zu den Nulldurchgängen des Primärstroms (119) Abtastungen vorzunehmen.

7. Der isolierte Wandler (1) nach Anspruch 6, wobei die Abtast-Halte-Schaltung (114) konfiguriert ist, zum Zeitpunkt der Nulldurchgänge oder innerhalb eines vorbestimmten Zeitintervalls um die Nulldurchgänge des Primärstroms (119) Abtastungen auszuführen.

8. Der isolierte Wandler (1) nach einem der Ansprüche 4 bis 7, ferner umfassend einen Regler (120), der konfiguriert ist für eine Rückkopplungsregelung eines Mittelwerts des Laststroms (112) in Übereinstimmung mit den Abtastwerten der Strommessspannung (115, V), indem ein Schaltbetrieb des mindestens einen Schalters (107) auf der Primärseite (105) geregelt wird.

9. Der isolierte Wandler (1) nach Anspruch 8, wobei der Regler (120) auf dem elektrischen Potential der Primärseite (105) des Wandlers (1) liegt.

10. Beleuchtungssystem (3), umfassend: einen isolierten Wandler (1) nach einem der Ansprüche 1 bis 9; und ein LED-Leuchtmittel (102), das von den Ausgangsklemmen des isolierten Wandlers (1) gespeist wird.

## Revendications

1. Convertisseur isolé (1) à commutation côté primaire, doté de bornes de sortie (101) pour piloter des moyens d'éclairage à LED (102), comprenant :
un transformateur (103, 104) configuré pour coupler un côté primaire (105) et un côté secondaire (106) du convertisseur (1) ; et
au moins un interrupteur (107) sur le côté primaire (105) ;
dans lequel le côté secondaire (106) comprend un condensateur de lissage (121) pour lisser un courant secondaire (111) induit dans un enroulement secondaire (104) dudit transformateur (103, 104) connecté au côté secondaire (106) et pour fournir un courant de charge lissé (112) induit dans les moyens d'éclairage à LED (102) lorsqu'ils sont connectés aux bornes de sortie (101), et ce même pendant les périodes au cours desquelles aucun courant secondaire (111) n'est induit dans l'enroulement secondaire (104) ;
dans lequel le côté secondaire (106) comprend en outre un transformateur de détection de courant (108, 109, 110) pour détecter une indication du courant de charge (112) induit dans les moyens d'éclairage à LED (102) lorsqu'ils sont connectés aux bornes de sortie (101) ;
**caractérisé en ce que** le transformateur de détection de courant (108, 109, 110) comprend un enroulement primaire bifilaire (108, 109) comportant un premier conducteur (108) connecté à un second conducteur (109), les premier et second conducteurs (108, 109) étant enroulés en sens opposés de manière à induire des flux magnétiques mutuellement opposés dans le transformateur de détection de courant (108, 109, 110) ;
que le condensateur de lissage (121) est connecté entre l'une desdites bornes de sortie (101) et un nœud entre le premier conducteur (108) et le second conducteur (109) ;
de sorte que ledit premier conducteur (108) est configuré pour conduire un courant secondaire (111) induit dans l'enroulement secondaire (104) du transformateur (103, 104) connecté au côté secondaire (106), et ledit second conducteur (109) est configuré pour conduire le courant de charge (112).

2. Le convertisseur isolé (1) selon la revendication 1, dans lequel le convertisseur isolé (1) est un convertisseur flyback, un convertisseurflyback synchrone ou un convertisseur LLC.

3. Le convertisseur isolé (1) selon l'une quelconque des revendications précédentes, dans lequel le transformateur de détection de courant (108, 109, 110) comprend en outre un enroulement de détection secondaire (110) fournissant un courant de détection (113) en fonction du courant secondaire (111) et du courant de charge (112).

4. Le convertisseur isolé (1) selon la revendication 3, comprenant en outre un circuit d'échantillonnage et de maintien (114) pour échantillonner une tension de détection de courant (115, V) représentative du courant de détection (113) pendant une période de non-conduction d'un commutateur (116) du côté secondaire (106).

5. Le convertisseur isolé (1) selon la revendication 4, dans lequel la polarité de l'enroulement de détection secondaire (110) est agencée de manière à fournir un courant de détection positif (113) pendant la période de non-conduction du côté secondaire (106).

6. Le convertisseur isolé (1) selon la revendication 4 ou 5, comprenant en outre un circuit shunt (117) pour détecter une tension (118, V) indicative d'un courant primaire (119) injecté dans un enroulement primaire (103) du transformateur (103, 104) connecté au côté primaire (105) ; et dans lequel le circuit d'échantillonnage et de maintien (114) est configuré pour échantillonner de manière synchrone aux passages par zéro du courant du côté primaire (119).

7. Le convertisseur isolé (1) selon la revendication 6, dans lequel le circuit d'échantillonnage et de maintien (114) est configuré pour échantillonner au moment des passages par zéro du courant du côté primaire (119) ou dans une période de temps prédéterminée autour de ceux-ci.

8. Le convertisseur isolé (1) selon l'une quelconque des revendications 4 à 7, comprenant en outre un dispositif de commande (120) configuré pour assurer une régulation en boucle fermée de la valeur moyenne du courant de charge (112) en fonction des échantillons de la tension de détection de courant (115, V), en commandant le fonctionnement de commutation du ou des interrupteurs (107) sur le côté primaire (105).

9. Le convertisseur isolé (1) selon la revendication 8, dans lequel le dispositif de commande (120) est au potentiel électrique du côté primaire (105) du convertisseur (1).

10. Système d'éclairage (3), comprenant : un convertisseur isolé (1) selon l'une quelconque des revendications 1 à 9, et des moyens d'éclairage à LED (102) alimentés par les bornes de sortie dudit convertisseur isolé (1).
